Europäisches Patentamt

European Patent Office

Office européen des brevets

(11) Numéro de publication : **0 417 008 B1**

## (12) FASCICULE DE BREVET EUROPEEN

(45) Date de publication du fascicule du brevet :
**22.07.92 Bulletin 92/30**

(51) Int. Cl.⁵ : **G11C 16/06,** G11C 7/00

(21) Numéro de dépôt : **90402455.1**

(22) Date de dépôt : **06.09.90**

(54) **Dispositif de verrouillage à cellule à grille flottante jamais programmable.**

(30) Priorité : **07.09.89 FR 8911705**

(43) Date de publication de la demande :
**13.03.91 Bulletin 91/11**

(45) Mention de la délivrance du brevet :
**22.07.92 Bulletin 92/30**

(84) Etats contractants désignés :
**DE GB IT**

(56) Documents cités :
**WO-A-88/00372**
**US-A- 4 744 062**

(73) Titulaire : **SGS-THOMSON**
**MICROELECTRONICS S.A.**
**7, Avenue Galliéni**
**F-94250 Gentilly (FR)**

(72) Inventeur : **Wuidart, Sylvie**
**Cabinet Ballot-Schmit, 7, rue Le Sueur**
**F-75116 Paris (FR)**

(74) Mandataire : **Schmit, Christian Norbert Marie**
**et al**
**Cabinet Ballot-Schmit 7, rue Le Sueur**
**F-75116 Paris (FR)**

## Description

La présente invention concerne un dispositif irréversible de verrouillage d'accès à un circuit intégré, utilisable dans tous les domaines où il est nécessaire, à un moment donné, d'interdire de manière irréversible l'accès à certaines zones ou fonctions du circuit intégré.

Ce dispositif est particulièrement important pour limiter l'accessibilité interne d'un circuit intégré après tests, en sortie de fabrication. En effet, après fabrication, un circuit intégré doit être testé avec une couverture que l'on cherche sans cesse à améliorer. Il faut en particulier que l'accessibilité interne du circuit intégré soit maximale pendant le test. Mais cette accessibilité doit être restreinte ensuite, car un utilisateur du circuit ne doit avoir accès, après ces tests, qu'à une couche dite applicative. Il faut donc interdire certains chemins d'accès.

Par ailleurs, un utilisateur d'un circuit intégré programmable doit pouvoir particulariser ce circuit intégré par programmation d'une application. Il peut être alors particulièrement important d'interdire les modifications, ou même la lecture externe, d'informations contenues dans certaines zones mémoires. Il peut aussi être important de se prémunir de perturbations externes éventuelles qui pourraient affecter ces zones mémoires. Des dispositifs de verrouillage permettent de telles protections. Ces dispositifs sont par exemple requis dans les circuits intégrés sécurisés, tels les circuits des produits monétiques.

Dans l'état de la technique, en sortie de fabrication, ces dispositifs de verrouillage sont dans un état non verrouillé et équivalents à des interrupteurs fermés. Ces dispositifs sont programmables une seule fois de manière irréversible. Une fois programmés, après les tests, ils sont équivalents à des interrupteurs ouverts. Ces dispositifs sont même intégrés au circuit pour qu'il n'y ait pas de possibilité de les court-circuiter à nouveau. Leurs états sont pris en compte dans les équations logiques d'accès des zones mémoire ou des fonctions qu'ils contrôlent. On connait du document WO-A-88/00372 un dispositif de verrouillage qui comporte un circuit de commande de cellules pour les rendre ineffaçables.

On connaît aussi des dispositifs de verrouillage à fusibles programmables. Chaque fusible, réalisé par exemple par une très fine couche de silicium polycristallin, est alimenté en courant par un transistor. Quand un courant circule pendant un certain temps, un échauffement local se produit, provoqué par la section très fine du fusible. Cet échauffement suffit à volatiliser le métal : le fusible est dit claqué. En fait, il arrive que le fusible ne claque pas. En pratique, un dispositif à fusibles n'est donc pas très fiable.

L'invention a donc pour but de réaliser un dispositif de verrouillage qui n'a pas cet inconvénient. Elle utilise des caractéristiques connues des cellules EEPROM qu'il convient de rappeler.

Une cellule EEPROM est une cellule effaçable et programmable électriquement. Elle comporte un transistor à grille flottante. La grille flottante, interposée entre une grille de commande du transistor et une zone canal de conduction du transistor, peut recevoir des charges électriques. Ces charges peuvent imposer un état de conduction du transistor indépendant d'une commande appliquée sur la grille de commande. Dans une cellule EEPROM, les charges électriques sont injectées dans la grille flottante par l'application d'un champ électrique important. Une telle cellule présente la particularité d'avoir une tension de seuil nulle en sortie de fabrication. Elle est vierge. On rappelle que la tension de seuil est la tension minimale en valeur absolue, qu'il faut appliquer sur la grille de commande pour qu'un canal de conduction se forme dans la zone canal. Une cellule EEPROM, à canal de type N, a une tension de seuil positive, de l'ordre de 5 volts si la cellule est effacée. Si la cellule est programmée, sa tension de seuil est négative, de l'ordre de -2 volts.

Les circuits de lecture des cellules mémoires comportent un circuit de sélection qui applique une impulsion de commande sur la grille de commande des transistors des cellules mémoires de chaque ligne. Pour une valeur de tension de grille classique, de l'ordre de 1,5 volts, la cellule EEPROM décrite conduit du courant quand elle est programmée, car on lui applique une tension de grille supérieure à sa tension de seuil. La cellule EEPROM ne conduit pas de courant quand elle est effacée.

Dans l'invention, on met à profit le fait que la cellule EEPROM, quand elle est vierge, se comporte comme si elle était programmée. Aussi, dans l'invention, on s'arrange pour interdire la programmation de la cellule EEPROM. Dans ces conditions, elle ne conduit du courant que si elle est vierge. Une fois qu'elle est effacée, elle ne conduit plus. Comme elle ne peut plus être programmée, elle reste dans cet état : on a le dispositif de verrouillage recherché.

L'invention a donc pour objet un dispositif de verrouillage de l'accès à tout ou partie d'un circuit intégré, qui comporte une cellule à EEPROM jamais programmable avec un dispositif de verrouillage de l'accès à tout ou partie d'un circuit intégré, la cellule EEPROM jamais programmable ayant un transistor à grille flottante muni d'un limiteur de tension sur sa zone drain et/ou sur sa zone source.

Les caractéristiques d'une cellule EEPROM conforme à l'invention sont données dans la description qui suit et qui est faite en référence aux figures annexées. Cette description et ces figures ne sont faits qu'à titre indicatif et nullement limitatif de l'invention. Dans ces figures :

– la figure 1 montre un exemple d'un dispositif deverrouillage muni d'une cellule EEPROM conforme à l'invention,

– la figure 2.a montre un schéma électrique équivalent d'une cellule EEPROM conforme à l'invention,

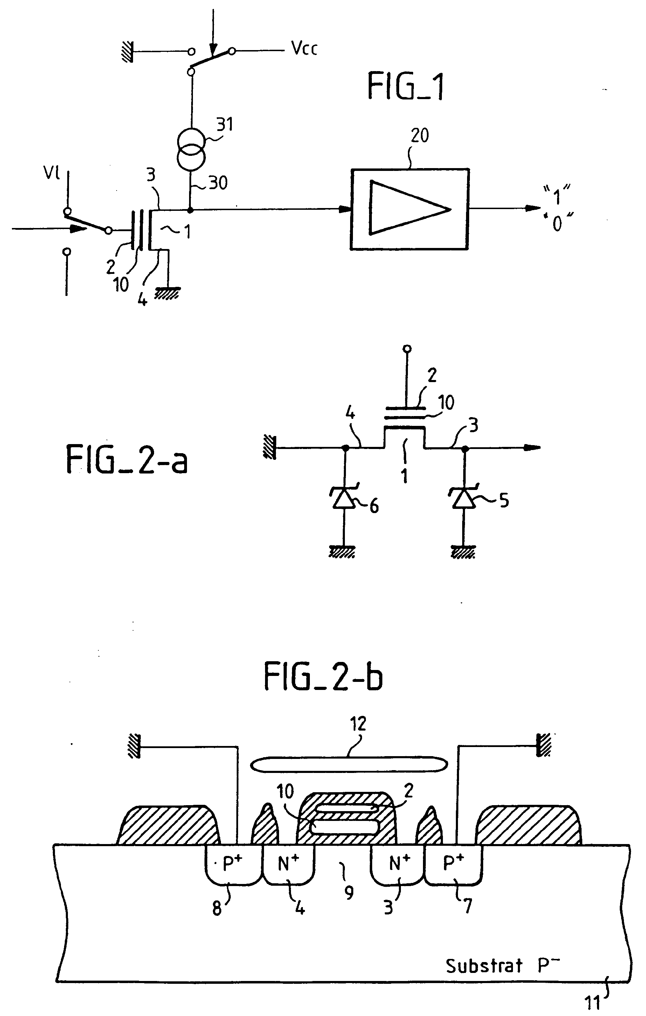

– la figure 2.b est une vue en coupe schématique d'une cellule selon la figure 2.a.

La figure 1 montre un dispositif de verrouillage selon l'invention. Une cellule EEPROM 1 a une zone source 4 reliée à la masse. Une zone drain 3 est alimentée par un générateur de courant de polarisation commandé par un circuit de sélection de la cellule. Dans une technologie duale, on inversera les rôles respectifs des zones source et drain. Une tension de lecture VI commandée par un circuit de sélection non représenté, est appliquée sur la grille de commande 2 de la cellule EEPROM. La cellule est par exemple sélectionnée par le décodage d'une adresse de base d'une zone mémoire qu'elle protège. Une tension de lecture de l'ordre de 1,5 volt est alors appliquée sur la grille 2. Avant la sélection, une ligne de bit 30, à laquelle est reliée la cellule, est alimentée par un générateur 31 à une tension de l'ordre de 5 volts. Un circuit de lecture 20, (sense, en littérature anglo-saxone), centré sur une tension de seuil comprise entre 0 et 5 volts, en général on prend la valeur moyenne 2,5 volts, détecte un "1" si la cellule est vierge et un "0" si la cellule est effacée. En effet, si la cellule est vierge, sa tension de seuil est égale à 0 volt. Elle se comporte, au moment de la sélection, comme un circuit fermé. Dans ces conditions, la tension sur la ligne de bit 30 chute. Cette chute est détectée dans le circuit 20. Par contre, si la cellule 1 a été effacée, elle se comporte comme un circuit ouvert quelle que soit la commande appliquée. Il n'y a alors plus de chute de tension détectée. C'est l'information en sortie du détecteur 20 qui valide ou non le décodage de la zone mémoire.

On peut ainsi avoir un bloc mémoire EEPROM non programmable dans un circuit intégré, chaque cellule verrouillant une fonction particulière.

Les figures 2.a et 2.b montrent une cellule EEPROM jamais programmable selon l'invention. La cellule EEPROM 1 est commandée sur sa grille de commande 2 par une tension VI. Entre la zone drain 3 et la masse, on a un limiteur de tension 5, qui limite la tension entre le drain et la masse à 5 volts. Entre la zone source 4 et la masse, on a un autre limiteur de tension 6 qui joue le même rôle. Sur la figure 2b, les zones drain 3 et source 4 sont des régions de dopage d'un type donné, par exemple N, dans un substrat de type opposé, par exemple P. Le limiteur de tension 5, respectivement 6, est une diode Zener, réalisée d'une manière préférée (figure 2.b) en joignant à la zone drain 3, respectivement source 4, une zone de dopage opposé 7, respectivement 8, à l'extérieur de la zone canal 9. Les zones de dopage opposé 7 et 8 sont connectées à la masse. Les zones 7 et 8 ont un dopage de même type que celui du substrat 11. Si la cellule est réalisée dans un caisson, les zones 7 et 8 sont dopées avec un même type d'impuretés que celui du caisson dans lequel est réalisé la cellule. Il faut en outre que ces zones soient plus dopées que le substrat, ou le caisson le cas échéant.

Dans l'exemple de la figure 2b, les zones 7 et 8 sont dopées P.

Pour expliquer les phénomènes physiques mis en oeuvre, il faut rappeler les principes d'effacement et de programmation d'une cellule EEPROM.

Prenons par exemple une cellule EEPROM à zone canal de type N. On efface cette cellule 1 en mettant sa grille de commande 2 à un potentiel très positif, de l'ordre de 15 volts et plus et sa zone drain 3 à la masse : des électrons sont piégés sous la grille flottante 10 sous l'effet d'un champ électrique puissant ainsi créé. Ils induisent une barrière de potentiel qui s'oppose à la formation d'un canal de conduction dans la zone canal 9: la tension de seuil de la cellule est augmentée. Typiquement, la tension de seuil prend une valeur de l'ordre de 5 volts.

Programmer une cellule EEPROM effacée consiste à faire partir les électrons de la grille flottante 10. Pour cela, on porte la grille de commmande à la masse et la zone drain à un potentiel très positif, de l'ordre de 15 volts et plus. Les électrons piégés dans la grille flottante sont alors évacués. La tension de seuil de la cellule est diminuée. Typiquement, la tension de seuil prend une valeur de l'ordre de -2 volts. La raison de cette tension de seuil négative provient du fait que, pour être sur d'avoir bien programmé la cellule, on maintient l'opération de programmation pendant un temps supérieur à celui nécessaire pour ne faire partir que les électrons préalablement piégés. Ce faisant, on fait partir également de la grille flottante des électrons libres qui contribuent à la neutralité électrique du matériau de la grille flottante. De cette manière, on importe en quelque sorte des trous.

C'est en fait la différence de potentiel qui est importante, donnant la direction du champ électrique et donc du mouvement des électrons. Pour la programmation, on pourrait ainsi mettre la grille de commande à un potentiel très négatif et la zone drain à la masse : la différence de potentiel serait inchangée. Mais en pratique, il n'est pas possible de mettre la grille de commande à un potentiel négatif, car la logique de commande des cellules qui est rattachée au circuit intégré va toujours s'y opposer.

Dans certains cas, on peut effacer et programmer la cellule de la même façon en utilisant la zone source 4 à la place de la zone drain 3, puisque ces deux zones sont indifférenciées. Ceci est la raison pour laquelle, dans l'invention, on place un limiteur de tension sur chaque zone source et drain.

Il faut remarquer de plus qu'il est possible de programmer la cellule en l'exposant à des rayons ultraviolet. Ceci n'est seulement possible que si sa grille flottante n'est pas protégée par un masque optique. Ce masque optique peut être par exemple réalisé sous la forme d'un pavé de métal 12 superposé au circuit intégré.

Si on place un limiteur de tension 5, respectivement 6, sur la zone drain 3, respectivement source 4, on empêche la programmation électrique, car on ne peut plus appliquer un potentiel très positif sur ces zones, et il n'est pas possible de mettre un potentiel très négatif sur la grille de commande, comme on l'a vu plus haut. Si de plus on met un pavé de métal 12 sur la grille de commande, on empêche la programmation par rayonnement ultra-violet on a une cellule EEPROM jamais programmable.

La description et le raisonnement que l'on vient de faire pour une cellule EEPROM à zone canal de type N est applicable de la même manière à une cellule EEPROM à zone canal de type P, en inversant les polarités et le type de charges.

Le limiteur de tension 5, respectivement 6, est par exemple une diode Zener réalisée comme on l'a déjà vu plus haut, en joignant à la zone drain 3, respectivement source 4, une zone de dopage opposé 7, respectivement 8, à l'extérieur de la zone canal 9. Les zones de dopage opposé 7 et 8 sont connectées à la masse. On obtient une jonction PN polarisée en inverse, dont on peut montrer qu'elle est une diode Zener, caractérisée par une tension Zener ayant une valeur comprise entre 5 et 6 volts. Pour la réalisation pratique des diodes Zener, on peut admettre, à l'implantation de dopage, un léger recouvrement de la zone dopée ultérieurement (7 ou 8), dans la zone voisine dopée préalablement (3 ou 4) en un type opposé.

## Revendications

1. Dispositif de verrrouillage de l'accès à tout ou partie d'un circuit intégré, comportant une cellule EEPROM (1) avec un transistor à grille flottante (10) caractérisé en ce que le transistor est muni d'un limiteur de tension (5,6) sur sa zone drain (3) et/ou sur sa zone source (4) à ce que la cellule EEPROM n'est jamais programmable.

2. Dispositif selon la revendication 1, caractérisé en ce que le limiteur de tension sur chaque zone source et/ou drain de la cellule EEPROM est une diode zener réalisée simplement en joignant à chaque zone source et drain, une zone de dopage opposé (7,8) mise à la masse et placée à l'extérieur de la zone canal (9) de la cellule EEPROM.

3. Dispositif selon l'une quelconque des revendications 1 ou 2, caractérisé en ce qu'il comporte un pavé de métal (12) sur la grille de commande de la cellule EEPROM pour interdire une programmation de cette cellule EEPROM par application d'un rayonnement ultra-violet.

4. Dispositif selon la revendication 3, caractérisé en ce qu'il est intégré dans le circuit intégré (11) dont il contrôle l'accès.

## Patentansprüche

1. Vorrichtung zur Verriegelung des Zugriffs insgesamt oder teilweise zu einem integrierten Schaltkreis, umfassend eine EEPROM-Zelle (1) mit einem Transistor mit schwebendem Gate (10), dadurch gekennzeichnet, daß der Transistor mit einem Spannungsbegrenzer (5, 6) an seiner Drain-Zone (3) und/oder seiner Source-Zone (4) versehen ist, damit die EEPROM-Zelle nie programmierbar ist.

2. Vorrichtung nach Anspruch 1, dadurch gekennzeichnet, daß der Spannungsbegrenzer an jeder Source- und/oder Drain-Zone der EEPROM-Zelle eine Zener-Diode ist, die einfach ausgeführt ist, indem mit jeder Source- und Drain-Zone eine Zone mit entgegengesetzter Dotierung (7, 8) verbunden wird, die an Masse gelegt und außerhalb der Kanal-Zone (9) der EEPROM-Zelle angeordnet ist.

3. Vorrichtung nach einem beliebigen der Ansprüche 1 oder 2, dadurch gekennzeichnet, daß sie einen Metallbelag (12) auf dem Steuergitter für die EEPROM-Zelle umfaßt, um eine Programmierung dieser EEPROM-Zelle durch Anwendung einer Ultraviolettstrahlung zu sperren.

4. Vorrichtung nach Anspruch 3, dadurch gekennzeichnet, daß sie in den integrierten Schaltkreis (11) integriert ist, deren Zugriff sie steuert.

## Claims

1. A device for blocking access to all or part of an integrated circuit comprising an EEPROM cell (1) comprising a floating gate transistor (10), characterized in that the transistor is equipped with a voltage limiter (5, 6) on its drain region (3) and/or on its source region (4) and in that the EEPROM cell is never programmable.

2. A device as claimed in claim 1, characterized in that the voltage limiter on each source and/or drain region of the EEPROM cell is a Zener diode formed simply by joining to each source and drain region a region of opposite doping (7, 8) connected to ground and located outside the channel region (9) of the EEPROM cell.

3. A device as claimed in either one of claims 1 and 2, characterized in that it comprises a metal layer (12) on the control gate of the EEPROM cell to prevent programming of this EEPROM cell by the application of an ultraviolet radiation.

4. A device as claimed in claim 3, characterized in that it is integrated in the integrated circuit (11) the access to which it controls.

FIG_1

FIG_2-a

FIG_2-b